# EUROPÄISCHE PATENTSCHRIFT

(11) **EP 3 621 766 B1**
(45) Veröffentlichungstag und Bekanntmachung des Hinweises auf die Patenterteilung: **05.01.2022**
(21) Anmeldenummer: 18703777.5
(22) Anmeldetag: 07.02.2018
(51) Int. Cl.: B23K 26/06, B22F 3/105, B23K 26/342, B23K 26/082, B29C 64/10

(54) **VERFAHREN ZUM ERZEUGEN EINER 3D-STRUKTUR MITTELS LASERLITHOGRAPHIE MIT GEÄNDERTER BELICHTDOSIS AN RANDABSCHNITTEN, SOWIE ENTSPRECHENDES COMPUTERPROGRAMMPRODUKT**
METHOD OF PRODUCING A 3D STRUCTURE BY MEANS OF LASER LITHOGRAPHY WITH A MODIFIED EXPOSURE DOSE AT EDGE PORTIONS, AND CORRESPONDING COMPUTER PROGRAM PRODUCT
PROCÉDÉ DE GÉNÉRATIPON D'UNE STRUCTURE 3D PAR LITHOGRAPHIE AU LASER À L'AIDE D'UNE DOSE D'ÉCLAIRAGE MODIFIÉE AUX SECTIONS DE BORD, AINSI QUE PRODUIT-PROGRAMME INFORMATIQUE CORRESPONDANT

(30) Priorität: 11.05.2017 DE 102017110241
(43) Veröffentlichungstag der Anmeldung: 18.03.2020
(60) Teilanmeldung: 21202455.8
(73) Patentinhaber: Nanoscribe Holding GmbH, 76344 Eggenstein-Leopoldshafen (DE)
(72) Erfinder: TANGUY, Yann, 67630 Lauterbourg (FR); LINDENMANN, Nicole, 75223 Niefern-Oeschelbronn (DE)
(74) Vertreter: DREISS Patentanwälte PartG mbB
(86) Internationale Anmeldenummer: PCT/EP2018/053016
(87) Internationale Veröffentlichungsnummer: WO 2018/206161

(56) Entgegenhaltungen:
- EP-A1- 0 606 839
- EP-A1- 3 093 123
- JP-A- 2015 124 395
- US-A1- 2015 183 165
- US-A1- 2016 046 070
- US-A1- 2017 066 052
- US-B1- 6 730 256

## Beschreibung

Die Erfindung betrifft ein Verfahren zum Erzeugen einer dreidimensionalen Gesamtstruktur mittels Laserlithographie gemäß dem Oberbegriff des Anspruchs 1 sowie ein hierzu angepasstes Computerprogrammprodukt gemäß Anspruch 14.

Derartige Verfahren finden insbesondere Verwendung bei der Erzeugung von Mikro- oder Nanostrukturen in Bereichen, in welchen hohe Präzision und gleichzeitig Gestaltungsfreiheit für die zu erzeugende Struktur erwünscht sind. Im Bereich der Laserlithographie, insbesondere dem sogenanntem direktem Laserschreiben (direct laser writing) ist es bekannt, dass die gewünschte Gesamtstruktur dadurch erzeugt wird, dass sequenziell eine Reihe von Teilstrukturen geschrieben werden, die sich insgesamt zu der gewünschten Struktur ergänzen. Üblicherweise wird die Gesamtstruktur lagenweise oder scheibenweise geschrieben.

Die einzelnen Teilstrukturen werden in der Regel rechnerisch aus der bekannten Gesamtstruktur ermittelt. Hierzu ist es bekannt, die Gesamtstruktur rechentechnisch in einer Gitterstruktur zu erfassen und in die Teilstrukturen zu zerlegen. Dabei tritt das Problem auf, dass die Teilstrukturen wiederum in der Gitterstruktur ermittelt werden und somit den exakten Verlauf der Gesamtstruktur nicht exakt wiedergeben. Außerdem hat die Laserlithographie prinzipbedingt eine gewisse Auflösungsgrenze, insbesondere gegeben durch die räumliche Ausdehnung des Fokusbereichs. Im Ergebnis können bei den aus verschiedenen Teilstrukturen zusammengesetzten Strukturen stufenartige Oberflächenverläufe auftreten. Dieser sogenannte "Step"-Effekt macht es problematisch, Gesamtstrukturen mit kontinuierlichen Oberflächenverläufen zu erzeugen. Ein anderes Problem besteht darin, dass bei der Erzeugung sehr dicht gepackter Strukturen sogenannte "Bulging"-Effekte auftreten können. Hierbei können bestimmte Strukturbereiche unerwünscht vergrößert oder aufgebläht geschrieben werden, was auf einen effektiv überhöhten Energieeintrag in das Lithographiematerial zurückzuführen ist, wenn Strukturdetails in unmittelbarer Nachbarschaft nacheinander geschrieben werden. Insgesamt kann es bei den bekannten Laserlithographie-Verfahren zu unerwünschten Abweichung zwischen der zu schreibenden Gesamtstruktur und der tatsächlich aus den zusammengesetzten Teilstrukturen resultierenden Struktur kommen.

Im Stand der Technik sind verschiedene Methoden bekannt, mit den genannten Problemen und Ungenauigkeiten umzugehen. Insbesondere kann eine erhöhte Genauigkeit dadurch erreicht werden, dass eine Zerlegung in kleinere Teilstrukturen erfolgt. Da damit aber auch die Anzahl der zu erzeugenden Teilstrukturen steigt, ist dieses Vorgehen zeitaufwendig. Denkbar ist auch, nur in Bereichen mit starken Konturänderungen eine feinere Rasterung der Gesamtstruktur vorzunehmen. Dies erhöht den Rechenaufwand bei der Erzeugung der Teilstrukturen und ist daher ebenfalls zeitaufwendig.

Aus der US 4,575,330 A1 oder der US 5,247,180 A sind Stereolithographie-Verfahren bekannt, wobei eine gewünschte Struktur aus blockartigen Teilstrukturen oder schichtweise in einem Bad aus flüssigem Lithographiematerial durch lokale Belichtung mit einem Schreibstrahl aufgebaut wird. Hierbei härtet der Schreibstrahl durch lokale Belichtung jeweils Strukturbereiche in einer Schicht unmittelbar an der Oberfläche eines Bades aus dem Lithographiematerial aus. Durch schrittweises Absenken eines Trägersubstrates in dem Bad aus Lithographiematerial wird dann die Struktur lageweise aufgebaut. Ein direktes Aufbauen der gewünschten Struktur in einem Volumen aus dem Lithographiematerial ist mit diesem Verfahren nicht möglich.

In US 2016 046070 A1 ist zur Herstellung eines optischen Wellenleiters ein Verfahren mit den Merkmalen des Oberbegriffs des Anspruchs 1 beschrieben.

Der Erfindung liegt die Aufgabe zugrunde, bei den eingangs genannten Laserlithographie-Verfahren unerwünschte Ungenauigkeiten zu kompensieren und größere Gestaltungsfreiheit hinsichtlich der zu erzeugenden Strukturen bereitzustellen. Außerdem ist es Ziel, die Prozesszeiten möglichst zu verkürzen.

Diese Aufgabe wird mit einem Verfahren gemäß Anspruch 1 gelöst. Hierbei handelt es sich um ein Laserlithographie-Verfahren, insbesondere sogenanntes direktes Laserschreiben, mittels einer Laserlithographie-Vorrichtung in einem Volumen an Lithographiematerial bzw. in einem mit Lithographiematerial ausgefüllten Volumen. Die Gesamtstruktur wird dadurch in dem Lithographiematerial geschrieben bzw. definiert, dass wenigstens eine Teilstruktur definiert wird (d.h. mit der Laserlithographie-Vorrichtung in das Lithographiematerial "geschrieben" wird), wobei die wenigstens eine Teilstruktur die gewünschte Gesamtstruktur zumindest annähert.

Zum Schreiben der Teilstruktur wird ortsaufgelöst in einem Fokusbereich eines Laser-Schreibstrahls unter Ausnutzung von zwei-Photonen-Absorption oder allgemein Multi-Photonen-Absorption eine Belichtungsdosis in das Lithographiematerial eingestrahlt. Dadurch wird das Lithographiematerial lokal verändert und insofern strukturiert. Zur finalen Definition der Struktur können sich in Entwicklungsschritte anschließen, z.B. zur Auslösung der nicht zur Gesamtstruktur beitragenden Bereiche des Lithographiematerials oder zur Aushärtung der Gesamtstruktur.

Zur Lösung der Aufgabe wird insbesondere vorgeschlagen, dass in der wenigstens einen Teilstruktur in denjenigen Randabschnitten, welche unmittelbar an eine Außenfläche der zu erzeugenden Gesamtstruktur angrenzen (und insofern von der Außenfläche selbst begrenzt sind), die Belichtungsdosis im Vergleich zu übrigen Bereichen der Teilstruktur verändert wird.

Zur Erzeugung der Teilstruktur wird der Fokusbereich des Laser-Schreibstrahls durch das Lithographiematerial verlagert und dadurch die Belichtungsdosis eingebracht. Zur Verlagerung des Fokusbereichs kann der Laser-Schreibstrahl z.B. mittels einer Strahlführungseinrichtung kontrolliert abgelenkt werden. Denkbar ist aber auch, dass das Lithographiematerial oder ein Substrat mit dem Lithographiematerial mittels einer Positioniereinrichtung kontrolliert relativ zu dem Laser-Schreibstrahl verlagert wird. Beide Konzepte zur Verlagerung können auch gemeinsam angewendet werden. Die Belichtungsdosis ist insbesondere eine Volumendosis an Strahlungsenergie. Wenn der Fokusbereich in den jeweiligen Randabschnitt verlagert wird, so wird gemäß der Erfindung die Belichtungsdosis verändert.

Das Einbringen der Belichtungsdosis mittels Multi-Photonen-Absorption ist bei der vorliegend angewandten Art des 3D-Laserschreibens besonders vorteilhaft. Hierzu ist das Lithographiematerial vorzugsweise derart ausgebildet und der Laser-Schreibestrahl derart auf das Lithographiematerial abgestimmt, dass eine Veränderung des Lithographiematerials (zum Beispiel lokale Polymerisation) nur mittels Absorption mehrerer Photonen möglich ist. Hierzu kann beispielsweise die Wellenlänge des Laser-Schreibstrahls derart gewählt (und damit die zugeordnete Quantenenergie derart bemessen sein), dass der für die Veränderung des Lithographiematerials erforderliche Energieeintrag nur durch gleichzeitige Absorption zweier oder mehrerer Quanten erreicht wird. Die Wahrscheinlichkeit für einen solchen Prozess ist intensitätsabhängig und im Fokusbereich gegenüber dem übrigen Schreibstrahl deutlich erhöht. Aus grundsätzlichen Überlegungen ergibt sich, dass die Wahrscheinlichkeit zur Absorption von zwei oder mehr Quanten vom Quadrat oder einer höheren Potenz der Strahlungsintensität abhängen kann. Im Gegensatz hierzu weist die Wahrscheinlichkeit für lineare Absorptionsprozesse eine andere Intensitätsabhängigkeit auf, insbesondere mit einer geringeren Potenz der Strahlungsintensität. Da beim Eindringen des Laser-Schreibstrahls in das Lithographiematerial eine Dämpfung erfolgt (zum Beispiel gemäß dem Beer'schen Gesetz), wäre ein Schreiben im Fokusbereich unter Ausnutzung linearer Absorptionsprozesse tief unter der Flüssigkeitsoberfläche des Lithographiematerials problematisch, das aufgrund der Dämpfung selbst bei einer Fokussierung unterhalb der Oberfläche in dem Fokusbereich nicht zwingend die höchste Absorptionswahrscheinlicht vorliegt. Der Mechanismus der Multi-Photonen-Absorption ermöglicht es hingegen, auch im Inneren eines Volumens aus Lithographiematerial die gewünschte Belichtungsdosis einzubringen und das Lithographiematerial lokal zu verändern. Vorrichtungen zum schrittweisen Absenken einer Trägerstruktur in einem Bad aus Lithographiematerial, wie es im Stand der Technik bekannt ist, ist somit nicht erforderlich.

Durch Einstrahlen der Belichtungsdosis wird das Lithographiematerial lokal chemisch und/oder physikalisch verändert, beispielsweise ausgehärtet oder polymerisiert. Die Größe des veränderten Bereichs bzw. "Voxels" im Lithographiematerial hängt von der Belichtungsdosis ab. Durch Variation der Belichtungsdosis kann somit die räumliche Ausdehnung des jeweiligen Strukturbereichs bzw. "Voxels" verändert werden. Durch geeignete Bemessung der Veränderung der Belichtungsdosis können somit die geschriebenen Bereiche in ihrer Größe derart angepasst werden, dass Fehlbereiche zwischen gewünschter Gesamtstruktur und den Teilstrukturen ausgeglichen werden.

Dies erlaubt es, die eingangs beschriebenen Ungenauigkeiten zu kompensieren, welche bei der Annäherung der Gesamtstruktur durch eine Teilstruktur oder mehrere Teilstrukturen auftreten können. Auch andere Probleme, die bei Laser-Lithographie typischerweise auftreten, können durch das genannte Vorgehen beseitigt werden. Beispielsweise können bei der Verwendung von Negativlacken unerwünschte Schrumpfungseffekte auftreten. Bei Negativlacken erfolgt ein Aushärten in dem Bereich, der mit Strahlungsenergie belichtet wird. Die Schrumpfungseffekte entstehen z.B. dadurch, dass das Lithographiematerial im ausgehärteten Zustand weniger Raum einnimmt, als im ursprünglichen (zum Beispiel viskosen) Zustand. Durch gezielte Variation der Belichtungsdosis kann dies ausgeglichen werden.

Die Variation der Belichtungsdosis ermöglicht es aber auch, gezielt eine gewünschte Oberflächenstruktur direkt zu erzeugen. Hierbei wird die Belichtungsdosis in den Randabschnitten, welche später die Oberfläche der Gesamtstruktur bereitstellen, nach einem definierten Muster variiert. Dies führt dazu, dass die in den Randabschnitten geschriebenen Voxel unterschiedliche Ausdehnungen aufweisen und so zur gewünschten Oberflächenstrukturierung beitragen.

Vorzugsweise wird die Belichtungsdosis ausschließlich in den Randabschnitten verändert. In den übrigen und insbesondere in den innenliegenden Bereichen der Teilstrukturen erfolgt dann vorzugsweise keine Variation der Belichtungsdosis. Dadurch können die für die Steuerung der Laserlithographie-Vorrichtung notwendigen Rechenoperationen vereinfacht werden.

Das beschriebene Verfahren ermöglicht es, die Gesamtstruktur mit einer vergleichsweise groben Rasterung durch die Teilstrukturen anzunähern. Gleichzeitig können kurze Prozesszeiten erzielt werden.

Als Lithographiematerial werden im vorliegenden Zusammenhang grundsätzlich solche Substanzen bezeichnet, deren chemische und/oder physikalische Materialeigenschaften durch die Bestrahlung mit einem Laser-Schreibstrahl veränderbar sind, beispielsweise sogenannte Lithographielacke. Je nach Art der durch den Schreibstrahl induzierten Veränderungen können Lithographiematerialien in sogenannte Negativlacke (bei welchem durch Bestrahlung eine lokale Aushärtung erfolgt oder die Löslichkeit in einem Entwicklermedium verringert wird) und in sogenannte Positivlacke (bei welchem durch die Bestrahlung lokal die Löslichkeit in einem Entwicklermedium erhöht wird) unterschieden werden.

Gemäß einer vorteilhaften Ausgestaltung wird die Gesamtstruktur dadurch definiert, dass eine Mehrzahl von Teilstrukturen nacheinander definiert wird, wobei die Teilstrukturen zusammen die Gesamtstruktur annähern. Hierbei ist insbesondere vorgesehen, dass nur in solchen Teilstrukturen, welche an eine Außenfläche der zu erzeugenden Gesamtstruktur angrenzen, die Belichtungsdosis wie beschreiben verändert wird. Hierbei wird in den jeweiligen Teilstrukturen wiederum in solchen Randabschnitten, welche unmittelbar an die Außenfläche angrenzen, die Belichtungsdosis im Vergleich zur übrigen Teilstruktur verändert. Je nach gewünschter Gesamtstruktur kann eine Teilstruktur auch vollständig als Randabschnitt ausgebildet sein, d.h. vollständig an die Außenfläche angrenzen.

Die Teilstrukturen sind beispielsweise schichtartig ausgebildet, so dass die Gesamtstruktur durch eine Mehrzahl von schichtartig aneinander angrenzenden (quasi übereinander liegenden) Teilstrukturen angenähert wird. Grundsätzlich können die Teilstrukturen aber auch eine andere Form aufweisen. Beispielsweise kann die Gesamtstruktur in mehrere, linienartig nebeneinander liegenden Bereiche, oder in sogenannte Voxel zerlegt werden. Auch komplexe Formen für die Teilstrukturen können vorteilhaft sein.

Die Veränderung der Belichtungsdosis in dem Randabschnitt kann grundsätzlich auf verschiedene Arten erfolgen.

Denkbar ist, dass die Belichtungsdosis im Randabschnitt im Vergleich zur übrigen Teilstruktur erhöht wird. Dieses Vorgehen ermöglicht es, den eingangs beschriebenen "Step-Effekt" auszugleichen. Insofern erhalten durch Vergrößerung der Belichtungsdosis die randständigen Raumbereiche effektiv ein größeres Volumen und können die unerwünschten Stufen oder Fehlbereiche aufgrund der rasterartigen Annäherung der Gesamtstruktur ausfüllen. Damit lassen sich auch Gesamtstrukturen mit kontinuierlich verlaufenden und gekrümmten bzw. gewölbten Oberflächen gut annähern.

Denkbar ist jedoch auch, dass die Belichtungsdosis in dem Randabschnitt im Vergleich zur übrigen Teilstruktur verringert ist. Mit diesem Vorgehen kann beispielsweise Überbelichtungseffekten entgegengewirkt werden, die bei kleinen und schnell hintereinander geschriebenen Strukturen auftreten können. Insbesondere kann dem sogenannten "Bulging-Effekt" entgegengewirkt werden, der aufgrund thermischer Akkumulation bei eng benachbarten und schnell aufeinanderfolgend geschriebenen Teilstrukturen zu einer ungewollten Ausdehnung des geschriebenen Bereichs führt.

Die Belichtungsdosis kann beispielsweise dadurch lokal verändert werden, dass eine Strahlungsleistung des Laser-Schreibstrahls verändert wird. Entsprechend kann auch die Intensität des Laser-Schreibstrahls verändert werden, z.B. mittels eines akustooptischen Modulators.

Nach einem anderen Aspekt erfolgt das Schreiben der Teilstruktur dadurch, dass der Fokusbereich durch das Lithographiematerial gescannt wird. Die Belichtungsdosis kann dann dadurch verändert werden, dass eine Geschwindigkeit der Verlagerung des Fokusbereiches entsprechend variiert wird. Dadurch wird die Verweildauer des Fokusbereichs in einem bestimmten Raumbereich effektiv verändert und somit die eingestrahlte Belichtungsdosis (im räumlichen und zeitlichen Mittel) variiert.

Beispielsweise erfolgt das Schreiben der Teilstruktur dadurch, dass der Fokusbereich entlang einer Scan-Kurve durch das Lithographiematerial verlagert wird, wobei die Scan-Kurve mehrere unmittelbar nebeneinanderliegende Kurvenabschnitte aufweist. Zur Variation der effektiven Belichtungsdosis kann dann zwischen dem Durchlaufen zweier aufeinanderfolgend durchlaufener und unmittelbar nebeneinander verlaufender Kurvenabschnitte eine Wartezeit abgewartet werden, während welcher keine Belichtungsdosis eingestrahlt wird. Insbesondere ist der Laser-Schreibstrahl während der Wartezeit deaktiviert. In dem Bereich, in welchem die Kurvenabschnitte nebeneinander verlaufen, hängt die effektive Belichtungsdosis davon ab, wie groß die Wartezeit ist. Somit kann die effektive (insbesondere zeitlich gemittelte) Belichtungsdosis in einem Randabschnitt dadurch verändert werden, dass in den Randabschnitten eine verlängerte oder verkürzte Wartezeit zwischen den Kurven im Vergleich zur übrigen innenliegenden Struktur angewendet wird.

Die Belichtungsdosis kann effektiv auch dadurch verändert werden, dass die unmittelbar benachbart liegenden Kurvenabschnitte in dem Randabschnitt einen anderen mittleren Abstand voneinander aufweisen, als in den übrigen Abschnitten der jeweiligen Teilstruktur. Liegen die Kurvenabschnitte im Mittel näher beieinander, so wird effektiv im räumlichen und zeitlichen Mittel eine erhöhte Belichtungsdosis eingebracht. Sind die Kurvenabschnitte im Mittel weiter voneinander beabstandet, so wird die effektive Belichtungsdosis reduziert.

Die Belichtungsdosis kann auch dadurch effektiv variiert werden, dass beim Schreiben der Teilstruktur der Fokusbereich eine Scan-Kurve durch das Lithographiematerial durchläuft und die Scan-Kurve innerhalb des Randabschnittes zumindest zweimal oder mehrfach durchlaufen wird.

Insgesamt kann somit die Belichtungsdosis einerseits durch Ansteuerung der Strahlungsabgabe des Laser-Schreibstrahls, andererseits durch Veränderung des Belichtungsmusters verändert werden.

Der Laser-Schreibstrahl kann grundsätzlich als Dauerstrichlaser oder als gepulster Laser ausgebildet sein. Ein gepulster Laser ist insbesondere durch eine intrinsische Pulsrate (z.B. MHz-Bereich) und eine intrinsische Pulslänge (z.B. Femtosekunden-Bereich) charakterisiert. Zur Veränderung der effektiven Belichtungsdosis (im zeitlichen Mittel) kann der Laser-Schreibstrahl zusätzlich zeitlich moduliert werden, z.B. mittels eines akustooptischen Modulators, und dadurch aufmodulierte Pulse erzeugt werden. Die aufmodulierten Pulse weisen wiederum eine aufmodulierte Pulslänge und eine aufmodulierte Pulsrate auf. Wie erläutert kann dabei der gepulste Laser-Schreibstrahl oder der Dauerstrichlaser entlang einer Scan-Kurve durch das Lithographiematerial verlagert werden.

Zur Ermittlung der Teilstrukturen wird die Gesamtstruktur vorzugsweise rechnerisch gerastert, insbesondere in Volumenelemente bzw. "Voxel" zerlegt und die Teilstrukturen jeweils durch eine vorzugsweise zusammenhängende Menge von Voxeln gebildet. Insofern wird die Teilstruktur aus einer Menge von formähnlichen oder formidentischen Volumenelementen (Voxeln) zusammengesetzt.

Der Laser-Schreibstrahl ist beispielsweise als eine Folge von aufmodulierten Laserpulsen ausgebildet, die eine aufmodulierte Pulsrate und eine aufmodulierte Pulslänge aufweisen. Dabei kann vorgesehen sein, dass ein aufmodulierter Laserpuls jeweils zum Schreiben eines Volumenelements dient. Ein Volumenelement kann jedoch auch durch mehrere aufmodulierte Pulse definiert werden. Die effektive (insbesondere zeitlich gemittelte) Belichtungsdosis kann z.B. dadurch verändert werden, dass die aufmodulierte Pulsrate und/oder die aufmodulierte Pulslänge variiert wird. Hierbei bezeichnet die aufmodulierte Pulsrate insbesondere die Zahl der aufmodulierten Pulse pro Zeiteinheit, die aufmodulierte Pulslänge insbesondere die Dauer der Einstrahlung pro Puls. Das Pulsen des Laser-Schreibstrahls kann z.B. dadurch erfolgen, dass die Intensität des Lasers zeitlich moduliert wird, z.B. mittels eines akustooptischen Modulators. Wie erläutert kann dabei der gepulste Laser-Schreibstrahl entlang einer Scan-Kurve durch das Lithographiematerial verlagert werden.

Grundsätzlich erfolgt die Zerlegung der Gesamtstruktur in die Teilstruktur oder die mehreren Teilstrukturen vorzugsweise softwaretechnisch und computergestützt. Insofern wird ein die Gesamtstruktur repräsentierender Datensatz (zum Beispiel CAD-Daten) bereitgestellt und ggf. auf einem Datenträger oder in einer flüchtigen Speichereinrichtung hinterlegt. Hieraus werden weitere Datensätze computergestützt ermittelt. Insbesondere wird ein Datensatz ermittelt, welcher die Teilstruktur bzw. die mehreren Teilstrukturen repräsentiert. Vorzugsweise erfolgt softwaretechnisch eine überlappungsfreie Zerlegung der Gesamtstruktur in die Teilstrukturen. Es kann aber auch vorteilhaft sein, einen Überlappungsbereich zwischen verschiedenen Teilstrukturen vorzusehen. In dem Überlappungsbereich kann auf die beschriebene Weise durch Variation der Belichtungsdosis ein glatter Übergang erzielt werden. Insgesamt wird in einer Recheneinrichtung mit Prozessor und Speicher ein die Gesamtstruktur repräsentierender Datensatz bereitgestellt und in einem Speicher hinterlegt. Hieraus werden mittels der Recheneinrichtung weitere Datensätze ermittelt und ebenfalls in dem Speicher hinterlegt. Vorzugsweise wird bei der Ermittlung des weiteren Datensatzes eine Rastergenauigkeit zugrunde gelegt, mit der die Gesamtstruktur angenähert wird. Bei der Zerlegung mit der genannten Rastergenauigkeit können wie erläutert Stufen und/oder Fehlbereiche auftreten. Dies kann zu eingangs erläuterten Problemen führen, wenn die Gesamtstruktur einen kontinuierlichen Oberflächenverlauf mit Krümmungen und Wölbungen aufweist.

Zur Lösung dieses Problems wird insbesondere vorgeschlagen, dass aus den genannten Datensätzen ein wiederum weiterer Datensatz (mittels der Recheneinrichtung) ermittelt wird und ggf. gespeichert wird. Dieser wiederum weitere Datensatz repräsentiert Abweichungen der Teilstruktur bzw. der Gesamtheit von mehreren Teilstrukturen von der Gesamtstruktur. Dies ermöglicht es, die Veränderung der Belichtungsdosis in Abhängigkeit von den lokalen Abweichungen in den Randabschnitten zu ermitteln. Tritt beispielsweise in dem Randabschnitt aufgrund der Rasterung eine Stufe auf, die in der tatsächlichen Gesamtstruktur nicht vorhanden ist, so führt dies zu einer sprunghaft erhöhten Abweichung. Die Belichtungsdosis kann dann in diesem Bereich entsprechen erhöht werden, um die Stufe auszufüllen.

Die verwendete Laserlithographie-Vorrichtung umfasst in der Regel optische Systeme (Strahlführungseinrichtung, Fokussiereinrichtungen, Linsen usw.). Solche optischen Systeme können mit Abbildungsfehlern behaftet sein, z.B. Bildfeldwölbung, Aberration oder Astigmatismus. Die Abbildungsfehler können ebenfalls unerwünschte Abweichungen zwischen der gewünschten Gesamtstruktur und der tatsächlichen, durch die wenigstens eine Teilstruktur angenäherte Struktur hervorrufen. Mit dem beschriebenen Verfahren können die Abweichungen korrigiert werden. Beispielsweise können die Abbildungsfehler ortsabhängig durch Kalibrierungsmessungen ermittelt und in Form eines charakteristischen Datensatzes gespeichert werden. Die Veränderung der Belichtungsdosis kann dann in Abhängigkeit des charakteristischen Datensatzes ortsabhängig ermittelt werden, um die Abweichung zu minimieren.

Die Funktion, mittels welcher die Belichtungsdosis aus der Abweichung ermittelt wird, kann verschiedene Charakteristiken aufweisen. Denkbar ist beispielsweise die Verwendung einer monoton steigenden Funktion. Wie erläutert können hierdurch unerwünschte Fehlbereiche ausgefüllt werden. Vorteilhaft kann jedoch auch die Verwendung einer lokal monoton fallenden Funktion sein, beispielsweise um Überbelichtungseffekte auszugleichen. Auch komplexere Funktionen können vorteilhaft sein.

Zur Veränderung der Belichtungsdosis wird erfindungsgemäß zunächst ein die Außenfläche der Gesamtstruktur repräsentieren Datensatz bereitgestellt wird und in dem Speicher hinterlegt, wobei mit der Recheneinrichtung lokale Steigungen und/oder Krümmungen der Außenfläche ermittelt werden. Die Veränderung der Belichtungsdosis erfolgt dann in Abhängigkeit der lokalen Steigung und/oder Krümmung desjenigen Bereiches der Außenfläche, welcher an den jeweiligen Randabschnitt angrenzt. Mit anderen Worten wird die Belichtungsdosis dort variiert, wo aufgrund von Krümmungen, Steigungen oder Krümmungsänderungen der Oberfläche der Gesamtstruktur die Annäherung durch die wenigstens eine Teilstruktur eine starke Abweichung von der gewünschten Gesamtstruktur aufweist. Auch hier können wiederum grundsätzlich monoton fallende oder monoton steigende Funktionen verwendet werden, um die Abhängigkeit der Belichtungsdosis von Steigung und/oder Krümmung wiederzugeben.

Wie erläutert, wird die Erfindung vorzugsweise computerimplementiert umgesetzt. Insofern umfasst eine Steuerungsvorrichtung für eine Laserlithographie-Vorrichtung vorzugsweise einen Computer, auf dem ein Computerprogramm ausführbar ist, welches eine Steuerungsfunktion für die Laserlithographie-Vorrichtung gemäß dem vorstehend beschriebenen Verfahren ausführt.

Die eingangs genannte Aufgabe wird insofern auch durch ein Computerprogrammprodukt gemäß Anspruch 14 gelöst.

Die Erfindung wird im Folgenden anhand der Figuren näher erläutert.

Es zeigen:
Figur 1: skizziertes Beispiel für eine laserlithographisch herzustellende Gesamtstruktur mit komplex geformter Außenfläche;
Figur 2: skizzierte Darstellung eines gewölbten Bereichs einer exemplarischen Außenfläche sowie annähernde Teilstrukturen;
Figur 3: skizzierte Darstellung zur Erläuterung unerwünschter Stufenbildung;
Figur 4: skizzierte Darstellung zur Erläuterung der Veränderung der Belichtungsdosis in Randabschnitten,
Figur 5: skizzierte Darstellung zur Erläuterung eines alternativen Vorgehens für die Veränderung der Belichtungsdosis in den Randabschnitten;
Figur 6: skizzierte Darstellung zur Erläuterung der Veränderung der Belichtungsdosis;
Figur 7: skizzierte Darstellung einer herzustellenden Gesamtstruktur mit strukturierter Außenfläche;
Figur 8: skizzierte Darstellung zur Erläuterung einer durch Belichtungsvariation der Belichtungsdosis hergestellten Struktur;
Figur 9: weiteres Anwendungsbeispiel der Belichtungsvariation in perspektivischer Draufsicht;
Figur 10: Schnitt durch die Struktur gemäß Figur 9.

In den Figuren sowie in der nachfolgenden Beschreibung sind für identische oder einander entsprechende Merkmale jeweils dieselben Bezugszeichen verwendet.

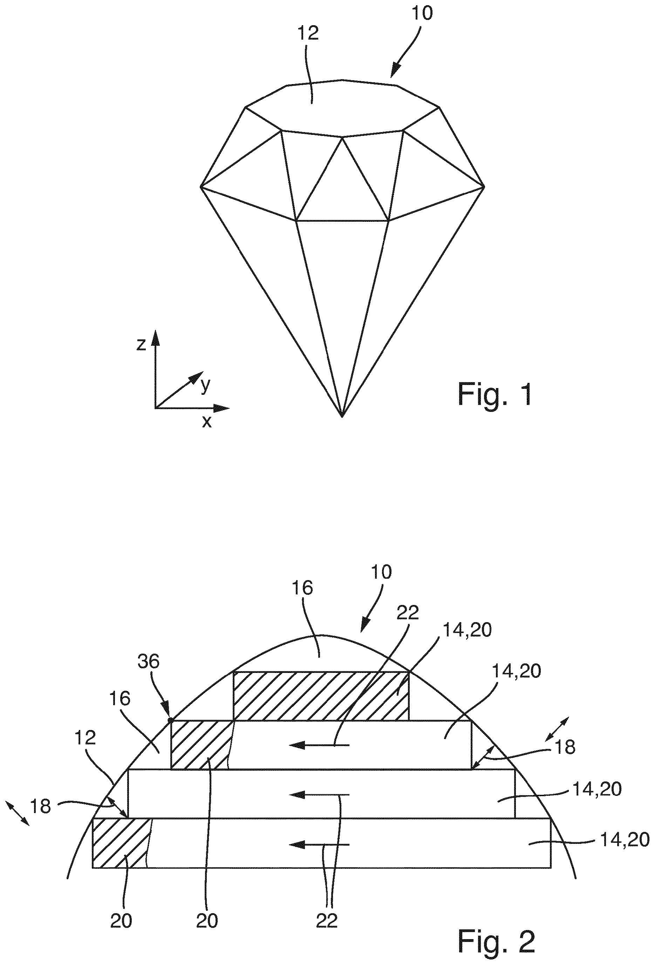

In der Figur 1 ist eine Gesamtstruktur skizziert, die mittels 3D-Laserlithographie in einem Volumen aus Lithographiematerial geschrieben werden soll. Derartige Strukturen weisen typischerweise Strukturmerkmale mit Abmessungen im Mikrometer- oder Nanometerbereich auf. Die Abmessungen der Gesamtstruktur können beispielsweise im Mikrometerbereich, Millimeterbereich oder Zentimeterbereich liegen.

Die Gesamtstruktur ist mit dem Bezugszeichen 10 bezeichnet und weist eine Außenfläche 12 auf, die einen Verlauf mit verschiedenen Steigungen und ggf. auch Krümmungen hat. Diese Bereiche können, wie eingangs erläutert, beim Schreiben problematisch sein. Die dargestellte Form ist nur beispielhaft. Die vorliegend beschriebenen Vorteile lassen sich insbesondere auch bei Formen mit Rundungen und Krümmungen erzielen.

Zur lithographischen Herstellung wird die Gesamtstruktur 10 bzw. ein diese Struktur repräsentierender Datensatz in beispielsweise eine Vielzahl von Teilstrukturen 14 bzw. entsprechenden Datensätzen zerlegt. Dies erfolgt üblicherweise rechnergestützt.

In Figur 2 ist skizziert, wie die zusammengesetzten Teilstrukturen 14 die gewünschte Gesamtstruktur 10 annähern. Hierzu ist in der Figur 2 lediglich ein Ausschnitt aus einer Gesamtstruktur 10 gezeigt. Die dargestellte Zerlegung in schichtartige Teilstrukturen 14 ist beispielhaft. Grundsätzlich können die Teilstrukturen 14 frei gewählt werden.

Da die Zerlegung in Teilstrukturen 14 aus praktischen Gründen üblicherweise mit einer gewissen Rasterung erfolgt, ergeben sich zwischen der gewünschten Außenfläche 12 der Gesamtstruktur 10 und der Menge an zusammengesetzten Teilstrukturen 14 Fehlbereiche 16, in welchen die Außenfläche 12 eine Abweichung 18 von den Teilstrukturen 14 aufweist. Diese Abweichungen 18 treten prinzipbedingt nur in Randabschnitten 20 der Teilstrukturen 14 auf, da diese Randabschnitte 20 an die gewünschte Außenfläche 12 der zu erzielenden Gesamtstruktur 10 angrenzen. Insbesondere kann die in Figur 2 ganz oben angeordnete Teilstruktur 14 insgesamt als Randabschnitt 20 angesehen werden, da diese Teilstruktur 14 vollständig and die Außenfläche 12 angrenzt.

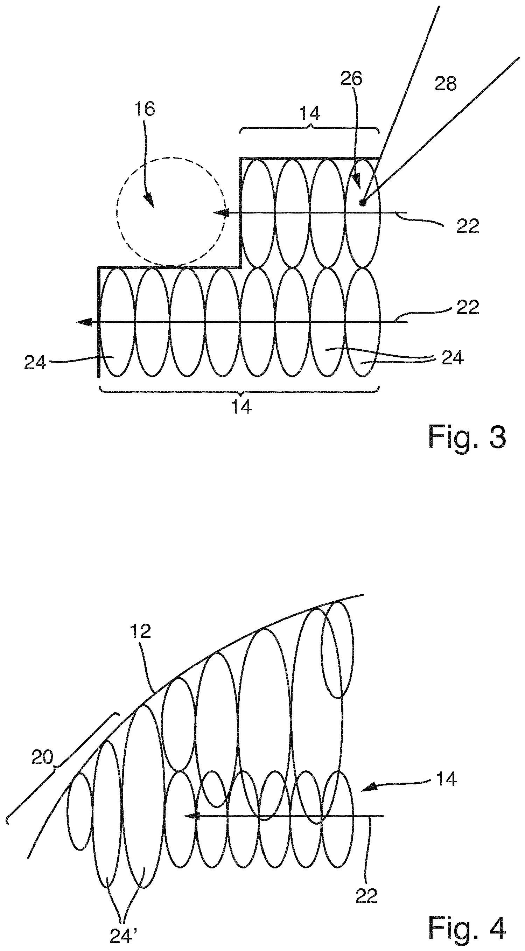

Wie in Figur 3 skizziert, erfolgt das Schreiben der Teilstrukturen dadurch, dass ein Fokusbereich 26 eines skizziert dargestellten Laser-Schreibstrahls 28 einer entsprechenden Laserlithographie-Vorrichtung (nicht dargestellt) durch das Volumen an Lithographiematerial (umgebend die gesamt Struktur) geführt wird. In dem Fokusbereich 26 wird eine Belichtungsdosis in das Lithographiematerial eingebracht.

Bei einer möglichen Ausgestaltung des Verfahrens werden die Teilstrukturen 14 in dem Lithographiematerial dadurch geschrieben, dass der Fokusbereich 26 eine Scan-Kurve 22 durch die jeweiligen Teilstrukturen 14 durchläuft (in den Figuren 2 und 3 ist die Scan-Kurve 22 jeweils abschnittsweise skizziert).

Beispielsweise können die Teilstrukturen 14 dadurch geschrieben werden, dass der Fokusbereich die Scan-Kurve 22 durchläuft und dabei eine Folge von Laserpulsen mit einer definierten Pulsrate und Pulslänge abgibt. Dadurch wird entlang der Scan-Kurve 22 eine Reihe von Voxeln 24 bzw. Volumenelementen 24 definiert, welche die Teilstruktur 14 bilden. Die Voxeln 24 sind untereinander formähnlich oder formidentisch. Wie eingangs erläutert, hängt die Größe des geschriebenen Voxels 24 mit der in das Lithographiematerial eingebrachten Belichtungsdosis zusammen.

Werden die einzelnen Teilstrukturen 14 mit jeweils im räumlichen Mittel mit lokal gleicher Belichtungsdosis geschrieben, so ergibt sich das in der Figur 3 skizzierte Bild. Insbesondere wären dann die einzelnen Voxel 24 gleich groß. Im Ergebnis würde dies zu dem in der Figur 2 erläuterten Ungenauigkeiten (Fehlbereichen 16, Abweichungen 18) führen.

Um dem entgegenzuwirken, wird gemäß dem vorliegenden Verfahren die Belichtungsdosis in den Randabschnitten 20 der Teilstrukturen 14 variiert, so dass sie von der Belichtungsdosis in den innenliegenden Bereichen der Teilstrukturen 14 abweicht.

Im Beispiel der Figur 4 wird in Voxeln 24' (bzw. Volumenelementen 24') der Teilstruktur 14, die innerhalb eines Randabschnitts 20 der Teilstruktur 14 liegen, die Belichtungsdosis erhöht. Dies führt dazu, dass die Voxel 24' eine größere räumliche Ausdehnung aufweisen. Dadurch können die Fehlbereiche 16 bzw. Abweichungen 18 verringert werden und die Oberfläche 12 kann besser angenähert werden.

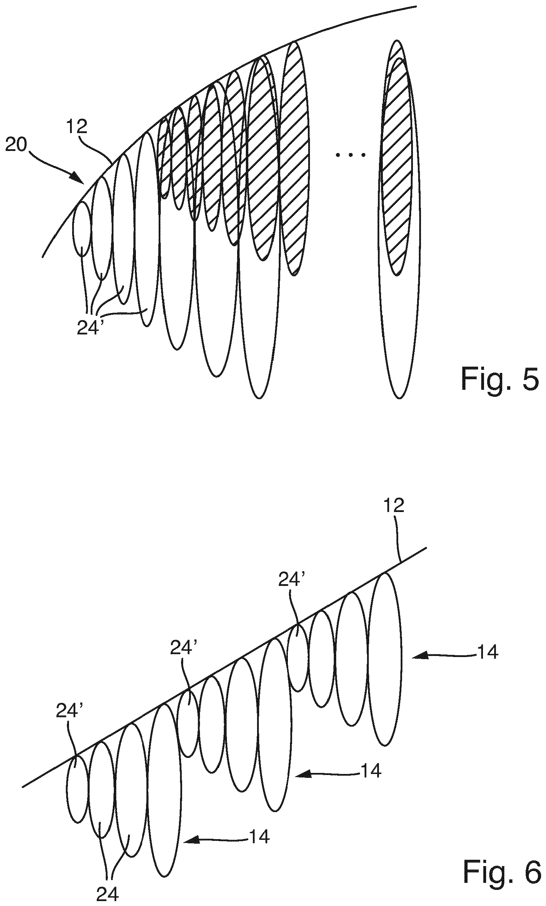

Je nach Verlauf der Außenfläche 12 kann eine bessere Annäherung durch die Teilstrukturen 14 auch dadurch erreicht werden, dass die Belichtungsdosis in den Randabschnitten 20 verringert ist (vergleiche Figur 5).

Die Figur 6 zeigt ein Beispiel dafür, dass durch stetige Verringerung der Belichtungsdosis in den Teilstrukturen 14 bei Annäherung an die Außenfläche 12 eine geneigt verlaufende Ebene mit hoher Genauigkeit angenähert werden kann. Die Ebene 12 verläuft insbesondere geneigt zur Erstreckungsrichtung der Teilstrukturen 14.

Der allgemeine Gedanke des erfindungsgemäßen Verfahrens ist jedoch nicht darauf beschränkt, dass die Belichtungsdosis in den Randabschnitten 20 entweder nur verringert oder nur vergrößert werden kann. Grundsätzlich liegt ein allgemeiner Aspekt der Erfindung darin, dass die Belichtungsdosis in den Randabschnitten 20, welche an die Außenfläche 12 angrenzen oder diese definieren, nach einem definierten Muster lokal verändert wird, um eine gewünschte Struktur zu erzeugen oder diese möglichst gut wiederzugeben (wenn die Teilstrukturen insgesamt zusammengesetzt sind).

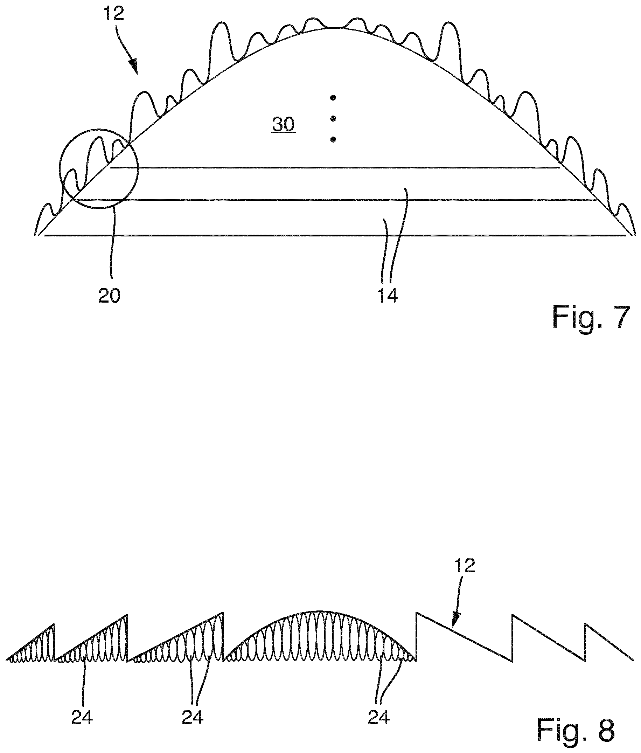

Insofern liegt ein vorteilhaftes Anwendungsgebiet der Erfindung auch darin, durch die Variation der Belichtungsdosis in den Randabschnitten 20 der jeweiligen Teilstrukturen 14 eine gewünschte Gesamtstruktur an der Außenfläche überhaupt erst zu erzeugen. Dies ist beispielhaft in Figur 7 skizziert, welche einen Linsenkörper 30 veranschaulicht, der in einem Lithographiematerial geschrieben werden soll. Die Außenfläche 12 des Linsenkörpers 30 weist eine komplexe Strukturierung auf. Wie erläutert wird der Linsenkörper 30 vorzugsweise dadurch geschrieben, dass sequenziell eine Mehrzahl von Teilstrukturen 14 geschrieben werden, welche den Linsenkörper 30 annähern. Zur Erzielung der Konturierten Außenflächen 12 wird in den Randabschnitten 20 der Teilstrukturen 14 die Belichtungsdosis lokal bedarfsgerecht variiert. Beispielsweise können Ausbuchtungen an der Außenfläche 12 dadurch erzielt werden, dass in randständigen Bereichen eine erhöhte Belichtungsdosis eingebracht wird und daher ein vergrößertes beschriebenes Raumvolumen in dem Lithographiematerial erzeugt wird.

Die Figur 8 veranschaulicht beispielsweise die Herstellung einer Struktur, deren Außenfläche 12 die Kontur einer fresnelschen Zonenplatte bzw. Fresnel-Linse wiedergibt. Die Belichtungsdosis zur Erzeugung der einzelnen Voxel bzw. Volumenelemente 24 wird gezielt derart variiert, dass die Außenfläche 12 möglichst präzise angenähert wird.

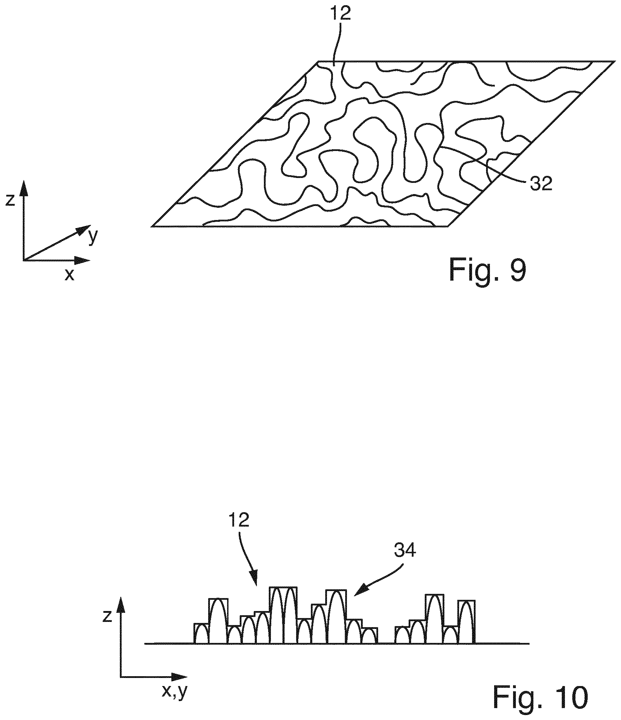

Ein weiteres Anwendungsbeispiel ist in den Figuren 9 und 10 skizziert. Die Außenfläche 12 weist hierbei Strukturbereiche 32 auf (vergleiche Figur 9), in welchen die Außenfläche 12 ein ausgeprägtes Höhenprofil 34 hat. Derartige Strukturen können zum Beispiel zur Kalibrierung in der Mikroskopie und insbesondere für Rasterkraftmikroskope verwendet werden.

Die Variation der Belichtungsdosis in den Randabschnitten 20 erfolgt insbesondere in Abhängigkeit einer Funktion, deren Eingangsgrößen aus dem Verlauf der Außenfläche der Gesamtstruktur 10 sowie ggf. aus dem Zerlegungsergebnis der Gesamtstruktur im Rahmen einer Rasterung durch Teilstrukturen 14 ermittelt werden. In der Figur 2 weist beispielsweise eine der Teilstrukturen 14 einen Bereich 36 auf, der an die tatsächliche Außenfläche 12 direkt angrenzt. Gemäß der Erfindung wird die Steigung und/oder Krümmung der Außenfläche 12 rechnerisch in dem Bereich 36 ermittelt. Die Veränderung der Belichtungsdosis in dem Randabschnitt 20 der jeweiligen Teilstruktur 14 wird gemäß der Erfindung in Abhängigkeit der in dem Bereich 36 lokal vorliegenden Steigung und/oder Krümmung erfolgen. Dadurch können Fehlbereiche 16 bzw. Abweichungen 18 ausgeglichen werden, die besonders in solchen Bereichen auftreten, in denen die Außenfläche 12 eine ausgeprägte Steigung und/oder Krümmung aufweist. Denkbar ist auch, dass die sich aufgrund der Rasterung ergebenden Abweichungen 18 berechnet werden.

Diese Abweichungen 18 stellen insofern Differenzen zwischen der Soll-Oberfläche, welche durch die Außenfläche 12 gebildet ist, und der Ist-Oberfläche, welche durch Teilstrukturen 14 in den Randabschnitten 20 definiert ist, dar. Die Veränderungen der Belichtungsdosis kann dann in Abhängigkeit der Abweichungen 18 erfolgen, wie weiter oben im Detail beschrieben.

## Patentansprüche

1. Verfahren zum Erzeugen einer dreidimensionalen Gesamtstruktur (10) mittels Laserlithographie in einem Lithographiematerial,
wobei die Gesamtstruktur (10) dadurch definiert wird, dass wenigstens eine Teilstruktur (14) definiert wird, wobei die wenigstens eine Teilstruktur (14) die Gesamtstruktur (10) annähert,
wobei die Teilstruktur (14) aus einer Menge von Volumenelementen (24) zusammengesetzt ist und zum Schreiben der Teilstruktur (14) in einem Fokusbereich (26) eines Laser-Schreibstrahls (28) unter Ausnutzung von Multi-Photonen-Absorption eine Belichtungsdosis in das Lithographiematerial eingestrahlt wird,
**dadurch gekennzeichnet, dass** in der wenigstens einen Teilstruktur (14) in solchen Randabschnitten (20), welche unmittelbar an eine Außenfläche (12) der zu erzeugenden Gesamtstruktur (10) angrenzen, die Belichtungsdosis und damit die räumliche Ausdehnung der Volumenelemente (24) im Vergleich zur übrigen Teilstruktur (14) verändert wird, wobei ein die Außenfläche (12) der Gesamtstruktur (10) repräsentierender Datensatz bereitgestellt wird, wobei lokale Steigungen und/oder Krümmungen der Außenfläche ermittelt werden, wobei die Veränderung der Belichtungsdosis in Abhängigkeit der lokalen Steigung und/oder Krümmung desjenigen Bereiches (36) der Außenfläche (12) erfolgt, welcher an den Randabschnitt (20) der Teilstruktur (14) angrenzt.

2. Verfahren nach Anspruch 1, wobei die Gesamtstruktur (10) dadurch definiert wird, dass eine Mehrzahl von Teilstrukturen (14) sequentiell definiert werden, wobei die Teilstrukturen (14) zusammen die Gesamtstruktur (10) annähern.

3. Verfahren nach Anspruch 1 oder 2, wobei die Belichtungsdosis in dem Randabschnitt (20) im Vergleich zur übrigen Teilstruktur (14) erhöht wird.

4. Verfahren nach Anspruch 1 oder 2, wobei die Belichtungsdosis in dem Randabschnitt (20) im Vergleich zur übrigen Teilstruktur (14) verringert wird.

5. Verfahren nach einem der vorherigen Ansprüche, wobei zur Veränderung der Belichtungsdosis eine Strahlungsleistung des Laser-Schreibstrahls (28) verändert wird.

6. Verfahren nach einem der vorherigen Ansprüche, wobei zum Schreiben der Teilstruktur (14) der Fokusbereich (26) des Laser-Schreibstrahls (28) durch das Lithographiematerial verlagert wird und zur Veränderung der Belichtungsdosis eine Geschwindigkeit der Verlagerung des Fokusbereichs (26) verändert wird.

7. Verfahren nach einem der vorherigen Ansprüche, wobei zum Schreiben der Teilstruktur (14) der Fokusbereich (26) des Laser-Schreibstrahls (28) eine Scan-Kurve (22) durch das Lithographiematerial mit mehreren unmittelbar nebeneinander liegenden Kurvenabschnitten durchläuft, wobei zwischen dem Durchlaufen zweier aufeinander folgend durchlaufener Kurvenabschnitte eine Wartezeit abgewartet wird, während welcher Wartezeit keine Belichtungsdosis eingestrahlt wird.

8. Verfahren nach einem der vorherigen Ansprüche, wobei zum Schreiben der Teilstruktur (14) der Fokusbereich (26) des Laser-Schreibstrahls (28) eine Scan-Kurve (22) durch das Lithographiematerial mit mehreren unmittelbar benachbart liegenden Kurvenabschnitten durchläuft, wobei die Belichtungsdosis in dem Randabschnitt (20) der jeweiligen Teilstruktur (14) dadurch verändert wird, dass die unmittelbar benachbart liegenden Kurvenabschnitte in dem Randabschnitt (20) einen anderen mittleren Abstand voneinander aufweisen, als in den übrigen Abschnitten der jeweiligen Teilstruktur (14).

9. Verfahren nach einem der vorherigen Ansprüche, wobei zum Schreiben der Teilstruktur (14) der Fokusbereich (26) des Laser-Schreibstrahls (28) eine Scan-Kurve (22) durch das Lithographiematerial durchläuft, und die Belichtungsdosis in dem Randabschnitt (20) dadurch verändert wird, dass die Scan-Kurve (22) innerhalb des Randabschnitts (20) mehrfach durchlaufen wird.

10. Verfahren nach einem der vorherigen Ansprüche, wobei der Laser-Schreibstrahl (28) als eine Folge von Laserpulsen ausgebildet ist, die mit einer Pulsrate eingestrahlt werden, wobei ein Laserpuls jeweils zum Schreiben eines Volumenelements (24) dient, und wobei die Belichtungsdosis dadurch verändert wird, dass die Pulsrate und/oder die Pulslänge variiert wird.

11. Verfahren nach einem der vorherigen Ansprüche, wobei ein die Gesamtstruktur (10) repräsentierender Datensatz bereitgestellt wird, und hieraus wenigstens ein weiter Datensatz ermittelt wird, welcher die wenigstens eine Teilstruktur (14) repräsentiert, wobei außerdem ein wiederum weiterer Datensatz ermittelt wird, welcher Abweichungen (18) der wenigstens einen Teilstruktur (14) von der Gesamtstruktur (10) repräsentiert, wobei die Veränderung der Belichtungsdosis in Abhängigkeit der lokalen Abweichung (18) in den Randabschnitten (20) erfolgt.

12. Verfahren nach Anspruch 11, wobei die Abhängigkeit durch eine Funktion gegeben ist, gemäß welcher die Belichtungsdosis mit der lokalen Abweichung (18) monoton steigt.

13. Verfahren nach Anspruch 11, wobei die Abhängigkeit durch eine Funktion gegeben ist, gemäß welcher die Belichtungsdosis mit der lokalen Abweichung (18) monoton fällt.

14. Computerprogrammprodukt, umfassend Befehle, die bei der Ausführung durch einen Computer diesen veranlassen, das Verfahren nach einem der Ansprüche 1 - 13 auszuführen.

## Claims

1. A method for producing a three-dimensional overall structure (10) by means of laser lithography in a lithography material
wherein the overall structure (10) is defined in that at least a partial structure (14) is defined, such that said at least one partial structure (14) approximates the overall structure (10),
wherein the partial structure (14) is composed of a set of volume elements (24) and, for the purposes of writing the partial structure (14), an exposure dose is radiated into the lithography material in a focal region (26) of a laser writing beam (28) while exploiting multi-photon absorption,
**characterized in that** the exposure dose and thus the spatial extent of the volume elements (24) is changed in comparison to the remaining partial structure (14) in the at least one partial structure (14) in such edge portions (20), which directly adjoin an external surface (12) of the overall structure (10) to be produced, wherein a data set representing the external surface (12) of the whole structure (10) is provided, wherein local slopes and/or curvatures of the external surface are determined, the change of the exposure dose being dependent on the local slope and/or curvature of the region (36) of the external surface (12) which adjoins the edge portion (20) of the partial structure (14).

2. The method of claim 1, wherein the overall structure (10) is defined by sequentially defining a plurality of partial structures (14), wherein the partial structures (14) together approximate the overall structure (10).

3. The method of claim 1 or 2, wherein the exposure dose in the edge portion (20) is increased compared to the remaining part structure (14).

4. The method of claim 1 or 2, wherein the exposure dose in the edge portion (20) is reduced compared to the remaining part structure (14).

5. The method according to any of the preceding claims,
wherein a radiation power of the laser writing beam (28) is changed in order to change the exposure dose.

6. The method according to any of the preceding claims,
wherein for writing the partial structure (14), the focus region (26) of the laser writing beam (28) is shifted through the lithography material and a speed of the shift of the focus region (26) is changed in order to change the exposure dose.

7. The method according to any of the preceding claims,
wherein for writing the partial structure (14), the focus region (26) of the laser writing beam (28) passes through a scan curve (22) through the lithography material with a plurality of immediately adjacent curve portions, wherein a waiting time is waited between passing through two consecutively traversed curve portions, during which waiting time no exposure dose is irradiated.

8. The method according to any of the preceding claims, wherein for writing the partial structure (14), the focus region (26) of the laser writing beam (28) passes through a scan curve (22) through the lithography material with a plurality of immediately adjacent curve portions, wherein the exposure dose in the edge portion (20) of the respective partial structure (14) is changed such that an average distance which the immediately adjacent lying curve portions in the edge portion (20) have from one another is different from the average distance which immediately adjacent lying curve portions have from one another in other portions of the respective partial structure (14).

9. The method according to any of the preceding claims, wherein for writing the partial structure (14), the focus region (26) of the laser writing beam (28) passes through a scanning curve (22) through the lithography material, and whereby the exposure dose in the edge portion (20) is changed by passing the scan curve (22) within the edge portion (20) several times.

10. The method according to any of the preceding claims, wherein the laser writing beam (28) is formed as a sequence of laser pulses which are irradiated at a pulse rate, wherein each laser pulse is used to write a volume element (24), and wherein the exposure dose is changed by varying the pulse rate and/or the pulse length.

11. The method according to any of the preceding claims,
wherein a data set representing the overall structure (10) is provided, and from this at least one further data set is generated, which represents the at least one partial structure (14), wherein in addition a second further data set is determined, which represents deviations (18) of the at least one partial structure (14) from the overall structure (10), wherein the change in the exposure dose is generated in dependence of the local deviation (18) in the edge portions (20).

12. The method of claim 11, wherein said dependence is given by a function according to which the exposure dose increases monotonically with the local deviation (18).

13. The method of claim 11, wherein said dependence is given by a function according to which the exposure dose falls monotonously with the local deviation (18).

14. A computer program product comprising instructions which, when executed by a computer, cause it to execute the method of any of claims 1 to 13.

## Revendications

1. Procédé pour générer une structure globale tridimensionnelle (10) par lithographie au laser dans un matériau de lithographie,
dans lequel la structure globale (10) est définie par le fait qu'au moins une structure partielle (14) est définie, dans lequel ladite au moins une structure partielle (14) se rapproche de la structure globale (10),
dans lequel la structure partielle (14) est composée d'un ensemble d'éléments de volume (24) et une dose d'éclairage est injectée dans le matériau de lithographie, dans une zone de focalisation (26) d'un rayon d'écriture laser (28), en utilisant une absorption de photons multiples, pour écrire la structure partielle (14),
**caractérisé en ce que**, dans ladite au moins une structure partielle (14), la dose d'éclairage et ainsi l'étendue dans l'espace des éléments de volume (24) est modifiée par rapport à la partie restante de la structure partielle (14), dans les zones de bord (20) qui sont directement adjacentes à une surface externe (12) de la structure globale (10) à générer, dans lequel un ensemble de données représentant la surface externe (12) de la structure globale (10) est prévu, dans lequel des gradients locaux et/ou des courbures locales de la surface externe sont déterminés, dans lequel la modification de la dose d'éclairage est effectuée en fonction du gradient local et/ou de la courbure local de la zone (36) de la surface externe (12) qui est adjacente à la zone de bord (20) de la structure partielle (14).

2. Procédé selon la revendication 1, dans lequel la structure globale (10) est définie en définissant séquentiellement une pluralité de sous-structures (14), dans lequel les structures partielles (14) se rapprochent ensemble de la structure globale (10).

3. Procédé selon la revendication 1 ou 2, dans lequel la dose d'éclairage dans la zone de bord (20) est augmentée par rapport au reste de la structure partielle (14).

4. Procédé selon la revendication 1 ou 2, dans lequel la dose d'éclairage dans la zone de bord (20) est réduite par rapport au reste de la structure partielle (14).

5. Procédé selon l'une quelconque des revendications précédentes, dans lequel une puissance de rayonnement du rayon d'écriture laser (28) est modifiée pour modifier la dose d'éclairage.

6. Procédé selon l'une quelconque des revendications précédentes, dans lequel, pour l'écriture de la structure partielle (14), la zone de focalisation (26) du rayon d'écriture laser (28) est déplacée par le matériau de lithographie et, pour la modification de la dose d'éclairage, une vitesse de déplacement de la zone de focalisation (26) est modifiée.

7. Procédé selon l'une quelconque des revendications précédentes, dans lequel, pour l'écriture de la structure partielle (14), la zone de focalisation (26) du rayon d'écriture laser (28) traverse une courbe de balayage (22) à travers le matériau de lithographie avec une pluralité de zones de courbe situées directement les unes à côté des autres, dans lequel un temps d'attente est attendu entre le passage de deux zones de courbe traversées successivement, pendant lequel aucun rayonnement de dose d'éclairage n'est appliqué.

8. Procédé selon l'une quelconque des revendications précédentes, dans lequel, pour l'écriture de la structure partielle (14), la zone de focalisation (26) du rayon d'écriture laser (28) traverse une courbe de balayage (22) à travers le matériau de lithographie avec une pluralité de zones de courbe immédiatement adjacentes, dans lequel la dose d'éclairage dans la zone de bord (20) de la structure partielle (14) respective est modifiée par le fait que les zones de courbe immédiatement adjacentes dans la zone de bord (20) sont à une distance moyenne différente les unes des autres que dans les zones restantes de la structure partielle (14) respective.

9. Procédé selon l'une quelconque des revendications précédentes, dans lequel, pour l'écriture de la structure partielle (14), la zone de focalisation (26) du rayon d'écriture laser (28) traverse une courbe de balayage (22) à travers le matériau de lithographie, et la dose d'éclairage dans la zone de bord (20) est modifiée par le fait que la courbe de balayage (22) est traversée plusieurs fois à l'intérieur de la zone de bord (20).

10. Procédé selon l'une quelconque des revendications précédentes, dans lequel le rayon d'écriture laser (28) est réalisé sous la forme d'une suite d'impulsions laser qui sont injectées à une cadence d'impulsion, dans lequel une impulsion laser est utilisée à chaque fois pour l'écriture d'un élément de volume (24), et dans lequel la dose d'éclairage est modifiée par le fait que la cadence d'impulsion et/ou la longueur d'impulsion est variée.

11. Procédé selon l'une quelconque des revendications précédentes, dans lequel il est prévu un ensemble de données représentant la structure globale (10) et au moins un autre ensemble de données supplémentaire représentant ladite au moins une structure partielle (14) est déterminé à partir de celui-ci, dans lequel encore un ensemble de données supplémentaire est déterminé à son tour, lequel représente des écarts (18) de ladite au moins une structure partielle (14) par rapport à la structure globale (10), dans lequel la modification de la dose d'éclairage est effectuée en fonction de l'écart local (18) dans les zones de bord (20).

12. Procédé selon la revendication 11, dans lequel la dépendance est donnée par une fonction selon laquelle la dose d'éclairage augmente de manière monotone avec l'écart local (18).

13. Procédé selon la revendication 11, dans lequel la dépendance est donnée par une fonction selon laquelle la dose d'éclairage diminue de manière monotone avec l'écart local (18).

14. Produit de programme informatique comprenant des instructions qui, lorsqu'elles sont exécutées par un ordinateur, amènent l'ordinateur à mettre en œuvre le procédé selon l'une quelconque des revendications 1 à 13.
